# FASCICULE DE BREVET EUROPEEN

(11) **EP 2 421 110 B1**
(45) Date de publication et mention de la délivrance du brevet: **15.08.2018**
(21) Numéro de dépôt: 11354036.3
(22) Date de dépôt: 05.07.2011
(51) Int. Cl.: H02H 3/08, H02H 3/347, G01R 31/02, G01R 31/08, G01R 19/175, H02H 3/34

(54) **Detection directionnelle d'un defaut à la terre avec un seul capteur**
Richtungserkennung eines Erdschlusses mit einem einzigen Sensor
Directional detection of an earth fault with a single sensor

(30) Priorité: 20.08.2010 FR 1003408
(43) Date de publication de la demande: 22.02.2012
(73) Titulaire: Schneider Electric Industries SAS, 92500 Rueil-Malmaison (FR)
(72) Inventeur: Verneau, Guillaume, 38050 Grenoble Cedex 09 (FR)
(74) Mandataire: Colette, Marie-Françoise

(56) Documents cités:
- EP-A1- 1 475 874
- FR-A1- 2 936 319
- JP-A- 11 355 955

## Description

### DOMAINE TECHNIQUE

L'invention concerne la détection directionnelle d'un défaut à la terre sans mesure de tension de la ligne. En particulier, l'invention est relative à un procédé de détection d'un défaut à la terre dans un réseau permettant en outre de déterminer si le défaut est localisé en amont ou en aval du point de détection. Le procédé selon l'invention repose sur l'analyse d'un seul signal représentatif du courant homopolaire, et en particulier de ses perturbations, permettant la localisation directionnelle.

Sous un autre aspect, l'invention concerne un dispositif de détection apte à mettre en oeuvre le procédé précédent. En particulier, le dispositif de détection directionnelle de défaut à la terre comprend des moyens permettant d'interpréter les perturbations du signal de courant homopolaire afin de donner une localisation relative du défaut sans utiliser de valeurs représentatives d'une tension.

L'invention concerne enfin un dispositif de signalisation de défaut et un relai de déclenchement comprenant un capteur du courant homopolaire du réseau et fournissant au dispositif de détection précédent les signaux permettant la signalisation, par exemple par voyant, ou le déclenchement d'un dispositif de coupure du réseau.

### ETAT DE LA TECHNIQUE

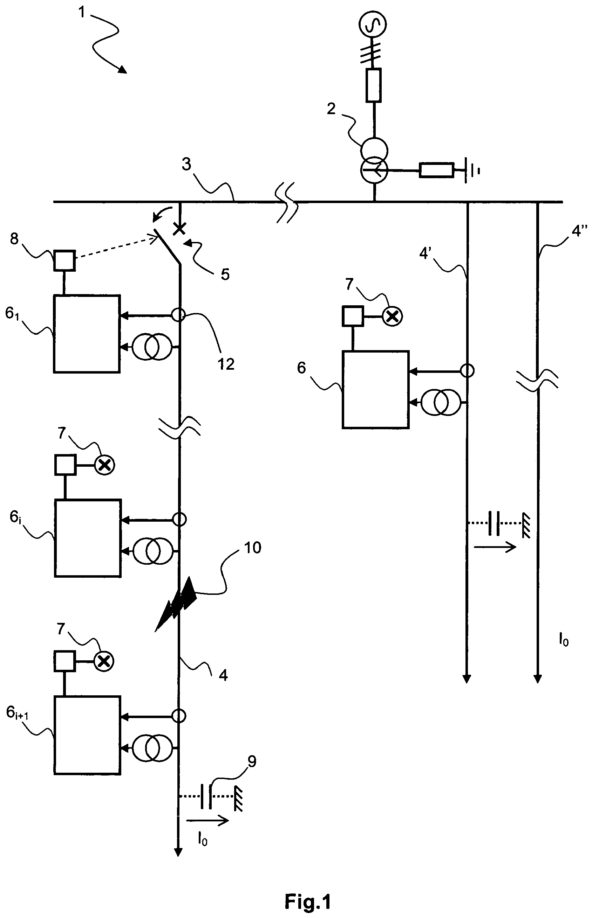

Les dispositifs de détection de défaut dans les réseaux triphasés permettent de déclencher la protection des charges et/ou d'aider à la localisation desdits défauts. Par exemple, la figure 1 représente un schéma d'un réseau 1 de distribution électrique moyenne tension qui comporte un transformateur 2 triphasé dont le secondaire est connecté à une ligne principale 3 de distribution ; le secondaire comporte par ailleurs un conducteur commun de neutre généralement connecté à la terre par une impédance. La ligne principale 3 alimente des lignes de départ 4, 4', 4", dont certaines peuvent comporter en tête un disjoncteur ou autre dispositif de coupure 5 les protégeant. Un dispositif de détection de défaut de type court-circuit 6 installé sur les lignes de départ 4', ou des tronçons de ligne 4, peut servir d'indicateur de passage de défaut, allumant par exemple un voyant lumineux 7 ; un dispositif 6₁ peut par ailleurs être associé ou intégré à un relai de protection 8 apte à commander l'ouverture des contacts du disjoncteur 5.

Entre les conducteurs de ligne 4 et la terre, en particulier si les lignes de départ 4 sont des câbles enterrés, peuvent apparaître des fortes valeurs de capacité 9, à l'origine de la circulation d'importants courants homopolaires I₀ en cas de défaut à la terre 10 ; par courant homopolaire I₀ (ou « *zero sequence current* » selon la terminologie anglo-saxonne), on entend, à un éventuel facteur trois près, la sommation vectorielle des différents courants de phase, ou encore le courant correspondant à la résultante instantanée des courants de phase, parfois appelé courant résiduel, qui correspond éventuellement au courant de défaut à la terre (« *ground default current* » selon la terminologie anglo-saxonne) ou au courant de fuite. Pour éviter une fausse détection d'un dispositif 6 de détection de défaut à la terre causée par une défaillance d'un départ voisin par liaison capacitive 9, des dispositifs et procédés ont été développés pour distinguer si un défaut à la terre 10 est localisé en aval du dispositif de détection 6ᵢ, ou en amont du dispositif 6ᵢ₊₁.

En particulier, les documents EP 1 475 874, EP 1 890 165, FR 2 936 319, FR 2 936 378 ou WO 2006/136520 proposent des solutions utilisant, entre autres, la mesure des courants par des capteurs adaptés 12. L'identification de la présence d'un défaut 10 est basée sur la détection de surintensités dans au moins une phase du réseau 1, et ce sur une durée minimale de défaut. Pour préciser la nature du défaut et/ou sa position relative, une mesure de la tension de chaque phase, voire d'autres paramètres, doit également être réalisée. Or les transformateurs de tension sont à la fois volumineux et coûteux ; qui plus est, ils ne sont pas toujours forcément adaptés pour une installation sur des lignes 4 déjà existantes, qu'elles soient aériennes ou souterraines.

Il apparaît ainsi que les dispositifs de détection de défaut existants ne sont pas optimisés pour une large mise en oeuvre en raison de leur complexité, notamment due au nombre de capteurs à mettre en place lorsqu'une localisation directionnelle est souhaitée.

### EXPOSE DE L'INVENTION

Parmi autres avantages, l'invention vise à pallier des inconvénients des dispositifs et procédés de détection directionnelle de défaut à la terre existants. En particulier, le principe de directionnalité mis en oeuvre repose sur l'analyse des effets en haute fréquence dus aux éléments parasites dans les réseaux, sans utilisation des courants de phase ni des tensions réseau, ce qui permet de pouvoir être mis en oeuvre avec un seul capteur et dans des équipements ne disposant pas de mémoire importante au niveau software et/ou hardware.

Sous un de ses aspects préférés, l'invention est relative à un procédé de détection directionnelle de défaut à la terre dans un réseau multiphasé comprenant un premier stade de détection du défaut par comparaison d'un signal représentatif du courant homopolaire circulant le tronçon de ligne surveillé à un seuil de détection. Le réseau est de préférence triphasé ; il peut comprendre un câble multipolaire ou plusieurs lignes de phase, en aérien ou en souterrain.

Si le premier stade détecte la présence d'un défaut à la terre dans ledit tronçon, le deuxième stade du procédé selon l'invention est déclenché. Le deuxième stade est basé sur le traitement du signal représentatif du courant homopolaire dudit tronçon, obtenu sur une durée prédéterminée suffisante, notamment supérieure à une demi-période de la fréquence propre du réseau, par exemple un nombre entier de périodes du réseau. Avantageusement, le signal est échantillonné, avec une fréquence d'échantillonnage relativement élevée, notamment supérieure à 400 fois la fréquence du réseau, par exemple de l'ordre de 20 kHz pour un réseau à 50 Hz.

Après l'acquisition du signal représentatif du courant homopolaire, le deuxième stade du procédé se poursuit par un traitement dudit signal pour permettre d'interpréter si le défaut détecté dans le premier stade se situe en amont du point de mesure du courant ; le traitement comprend la détermination du nombre de passages par zéro du courant homopolaire pendant la durée prédéterminée, et la comparaison de ce nombre à un premier seuil prédéfini, par exemple 10 : si le nombre de passages est inférieur au seuil, alors le défaut se situe en aval de la détection.

De préférence, le traitement comprend en outre la détermination de la dérivée du signal représentatif du courant homopolaire pendant la durée prédéterminée, le décompte du nombre de passages par zéro de ladite dérivée, et la comparaison à un deuxième seuil, par exemple 50. Il est ainsi possible de localiser le défaut en amont ou en aval du point de mesure du courant : si le premier seuil et le deuxième seuil sont dépassés, alors le défaut se situe en amont de la détection.

Selon un mode de réalisation préféré du procédé selon l'invention, ledit procédé de détection directionnelle est associé à un actionnement d'un dispositif de coupure pour isoler le tronçon à partir du point en aval duquel un défaut a été détecté.

Sous un autre aspect, l'invention se rapporte à un dispositif de détection directionnelle d'un défaut à la terre d'une ligne dans un réseau multiphasé, de préférence triphasé, adapté pour le procédé précédent. Le dispositif de détection directionnelle selon l'invention peut être associé à un capteur de courant, par exemple un tore de détection, ou un capteur de champ magnétique adapté, qui lui fournit le signal représentatif dudit courant. Le dispositif de détection directionnelle peut en outre faire partie d'un indicateur de passage de défaut, par exemple par activation de moyens d'alerte de type voyant si un défaut aval aux capteurs est détecté. Dans un mode de réalisation particulièrement préféré, le dispositif de détection directionnelle selon l'invention est associé à un relai de protection de la ligne, les moyens d'alerte provoquant l'actionnement d'un dispositif de coupure de la ligne permettant d'isoler le tronçon sur lequel un défaut a été détecté.

En particulier, le dispositif de détection directionnelle d'un défaut à la terre selon l'invention comprend des moyens pour recevoir un signal représentatif du courant de la ligne à surveiller ; avantageusement, les moyens de réception comprennent des moyens d'échantillonnage pour obtenir un grand nombre de valeurs discrètes, par exemple à fréquence 20 kHz pour un réseau à 50 Hz.

Le dispositif selon l'invention comprend des moyens de traitement du signal représentatif obtenu associés à des moyens d'activation desdits moyens de traitement, les moyens d'activation étant déclenchés par la détection de l'occurrence d'un défaut à la terre. De préférence, la détection de l'occurrence d'un défaut à la terre actionnant les moyens d'activation est réalisée par le dispositif selon l'invention qui comprend des moyens adaptés, notamment des moyens de comparaison du signal représentatif du courant homopolaire à un seuil de détection.

Les moyens de traitement du signal du dispositif selon l'invention comprennent des moyens pour déterminer le nombre de changements de signe du signal et pour comparer ce nombre à un seuil ; de préférence, des moyens de détermination de la dérivée du signal de courant homopolaire sont prévus, et en communication avec les moyens précédents. Les moyens de traitement du signal sont couplés en sortie à des moyens d'interprétation qui permettent de déterminer la position relative du défaut à la terre détecté par rapport au point d'obtention desdits signaux.

### BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.
La figure 1, déjà décrite, représente un réseau électrique dans lequel des dispositifs de détection de défaut terre peuvent être utilisés.
La figure 2 montre de façon schématique un signal représentatif du courant homopolaire lors de l'apparition d'un défaut, respectivement à l'amont et à l'aval du dispositif de détection.
La figure 3 illustre le procédé de détection selon un mode de réalisation préféré de l'invention.
La figure 4 représente un schéma bloc d'un dispositif de détection de défaut terre selon un mode de réalisation préféré de l'invention.

### DESCRIPTION DETAILLEE D'UN MODE DE REALISATION PREFERE

Le dispositif 20 de détection directionnelle de défaut 10 selon l'invention peut être utilisé dans tout réseau triphasé 1, tel que celui décrit en figure 1, en lieu et place des dispositifs 6 existants ; en particulier, bien que la description concerne un réseau 1 de fréquence propre F = 50 Hz, le dispositif et le procédé selon l'invention s'adaptent de façon immédiate aux autres fréquences, et à tout nombre de phases supérieur à deux. La description sera faite ci-après pour un réseau 1 équilibré, c'est-à-dire qu'en l'absence de défaut, le courant homopolaire I₀ (ou « *zero sequence current* » selon la terminologie anglo-saxonne) est nul, mais ceci n'est pas limitatif : il est possible de s'écarter de cette situation idéale.

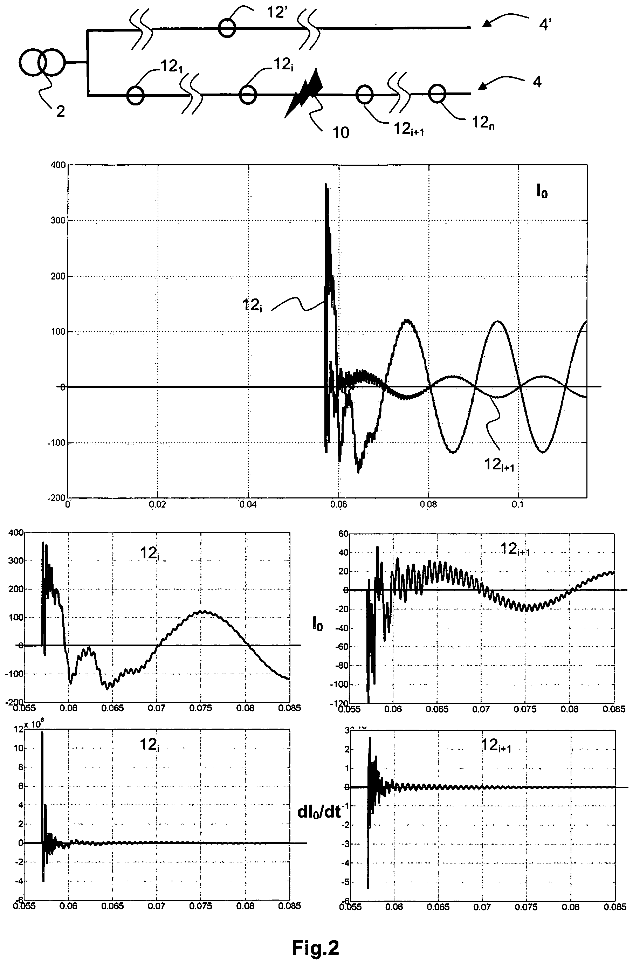

Lors de l'apparition d'un défaut à la terre 10 sur une ligne 4, le courant des phases en défaut devient (idéalement) nul en aval du défaut 10, alors qu'il est altéré en amont. Pour ce qui est des autres phases, bien qu'il soit ponctuellement altéré, le courant reste de forme quasi-constante, avec une amplitude légèrement modifiée. Ainsi, tel qu'illustré en figure 2, en amont du défaut 10, le courant homopolaire I₀ détecté par un capteur 12ᵢ est quasi-identique au courant de défaut à la terre, et a donc une amplitude relativement importante. Par contre, un dispositif 12ᵢ₊₁ de détection du courant homopolaire I₀ situé en aval du défaut 10, ou un dispositif 12' situé sur un départ adjacent, voient un courant homopolaire I₀ principalement dû aux retours capacitifs, qui a donc une amplitude plus faible que dans le cas précédent.

La porteuse des courants I₀ détectés par les dispositifs appropriés 12 est par ailleurs altérée par des oscillations haute fréquence (HF) dues aux résonances des éléments parasites du réseau 1, notamment les capacités et inductances, en particulier des lignes et des câbles ; des filtres sont classiquement associés aux moyens de détection des signaux de courant afin de s'affranchir de ces perturbations. L'invention opte pour une moindre qualité du signal détecté, de préférence sans filtrage, et utilise les oscillations parasites pour la détection directionnelle. De fait, les oscillations HF sont d'amplitude sensiblement constante et très inférieure à l'amplitude du courant homopolaire I₀ détecté. Très présentes juste après l'occurrence du défaut 10, notamment dans les 20 ms qui suivent, c'est-à-dire sur une période du réseau 1 à 50 Hz, sur une porteuse de faible amplitude telle que détectée en aval du défaut, ces oscillations entraînent de nombreux passages par zéro du signal de courant ; par contre, si sur la porteuse de forte amplitude du signal de courant détecté en amont du défaut, la forme générale est altérée, sans cependant beaucoup de changements de signes du courant transitoire. Cette différence entre les passages par zéro se retrouve pour la dérivée temporelle dI₀/dt du courant homopolaire. Dans le procédé selon l'invention, la quantité de passages par zéro du courant homopolaire et de la dérivée du courant homopolaire permettent ainsi de déterminer la position du défaut par rapport au dispositif de détection.

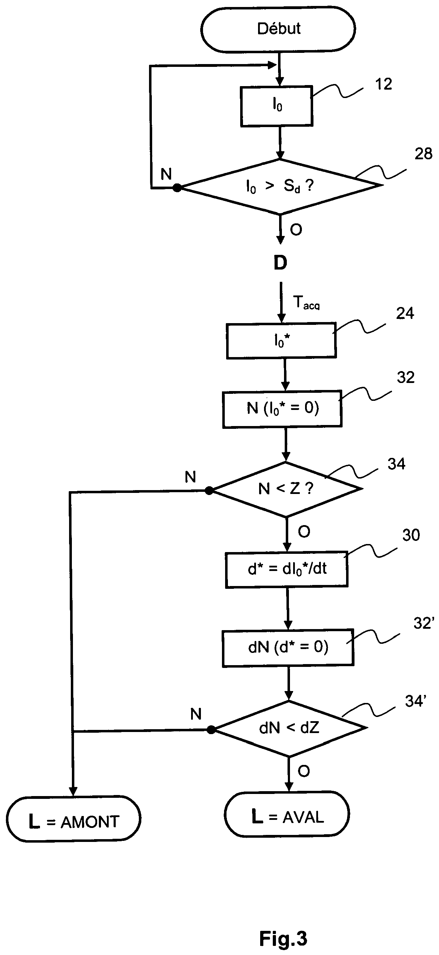

Il est par ailleurs avantageux, dans un procédé selon l'invention, d'utiliser le même courant homopolaire I₀ pour la détection initiale de la présence d'un défaut 10, notamment en comparant l'amplitude du courant détecté à un seuil S_{d}, qui peut être réglé à une valeur minimale de détection pour laquelle le capteur de courant 12 est homologué : voir figure 3. Ainsi, dans le procédé selon l'invention, une fois le défaut détecté D, le signal représentatif du courant homopolaire I₀ est acquis pour une durée d'acquisition T_{acq}, par exemple de l'ordre d'une période de réseau 1, ou au moins supérieure à une demi-période de la fréquence F du réseau 1, durée pendant laquelle les perturbations parasites altèrent le plus le signal de courant. Selon un mode de réalisation avantageux de l'invention, le signal I₀ est échantillonné afin de traiter ensuite des valeurs discrètes ; au vu de l'utilisation des parasites HF, la fréquence d'échantillonnage est suffisamment élevée, par exemple supérieure à 400 fois la fréquence du réseau 1, soit au moins 20 kHz pour un courant triphasé à 50 Hz.

Une fois, le courant homopolaire échantillonné I₀* obtenu, le nombre N de passages par zéro est déterminé par toute méthode, graphique ou autre ; de préférence, le signe du courant transitoire I₀* est déterminé, et le nombre de changements dudit signe est décompté. Le nombre N de passages par zéro est ensuite comparé à un seuil Z, choisi à l'installation sur le réseau 1 en fonction de ses caractéristiques capacitives et inductives, et notamment des caractéristiques des câbles et lignes. Si le seuil Z est dépassé par N, le défaut D est localisé L en amont de l'endroit où le courant homopolaire I₀ a été obtenu. De fait, bien que le nombre N de passages par zéro du courant homopolaire I₀ décroisse au fur et à mesure qu'on se rapproche du défaut 10, il a été constaté, tant pour un réseau linéaire 1 avec une charge répartie que pour un réseau linéaire 1 avec une charge en bout de ligne, que N < 10 pour tous les capteurs 12_{j,j} = _{1 → i} et N > 10 pour tous les capteurs 12_{j,j} = _{i+1 → n}.

Pour des réseaux comprenant des arborescences, le courant homopolaire I₀ sur un départ sain 4' peut être perturbé par le défaut 10 d'une branche adjacente, avec alors une faible amplitude ; l'influence relative des parasites HF sur le signal représentatif du courant homopolaire I₀ détecté par le capteur 12' peut alors générer un nombre de passages par zéro faible, notamment inférieur au seuil Z ; or, par convention, un défaut 10 localisé sur une branche 4 adjacente à l'endroit 12' de détection devrait être considérée comme amont. Il est donc avantageux, lorsque le seuil Z est dépassé, notamment pour ce type de réseau comprenant plus d'un départ 4, de poursuivre l'analyse par l'utilisation du signal dérivé par rapport au temps du courant homopolaire I₀, signal pour lequel l'influence des parasites est plus précise.

A cette fin, la dérivée par rapport au temps d* = dI₀*/dt du signal représentatif du courant homopolaire échantillonné obtenu sur la durée d'acquisition T_{acq} est déterminée. De la même façon, le nombre dN de passages par zéro de cette dérivée d* est décompté, et comparé à un seuil dZ. Si le seuil dZ est dépassé, le défaut est localisé en amont du point où le courant homopolaire I₀ a été obtenu ; sinon, il est en aval ; le seuil dZ est lui aussi choisi à l'installation sur le réseau 1 en fonction de ses caractéristiques capacitives et inductives, et notamment des caractéristiques des câbles et lignes.

Dans la pratique, pour tous les réseaux 1, un seuil dZ de l'ordre de 50 est approprié. De plus, il est à noter que lorsque dN < dZ, on a également N < Z : il y a cohérence des résultats. Il est donc possible que le procédé ne distingue pas les deux situations pour le traitement du signal de la dérivée d* et que, sans tenir compte de la comparaison entre N et Z, il soit procédé à la détermination de la dérivée d*, au décompte de son nombre de passages par zéro et à la comparaison au deuxième seuil dZ. En particulier, cette double comparaison permet de confirmer les résultats pour une détection d'un défaut survenant lorsque le courant de la phase concernée est proche de son passage à zéro sur sa sinusoïde de référence.

Afin de fiabiliser les résultats de détection directionnelle L, les valeurs de seuil précédentes peuvent être réglées en fonction des paramètres du réseau, et notamment des paramètres susceptibles d'influencer le principe selon l'invention, à savoir les caractères plus ou moins capacitif et plus ou moins inductif du réseau 1 considéré, lié principalement au type de câble ou de ligne utilisé (de fait, des études n'ont pas montré de dépendance à des paramètres tels que la résistance de défaut, le régime de neutre). En effet, la différence entre le nombre de passages par zéro entre l'amont et l'aval pour des lignes aériennes, avec des éléments parasites capacitifs plus faibles et des éléments inductifs plus forts que les câbles souterrains, est plus importante, et il est possible d'utiliser par exemple Z = 20 et dZ = 60.

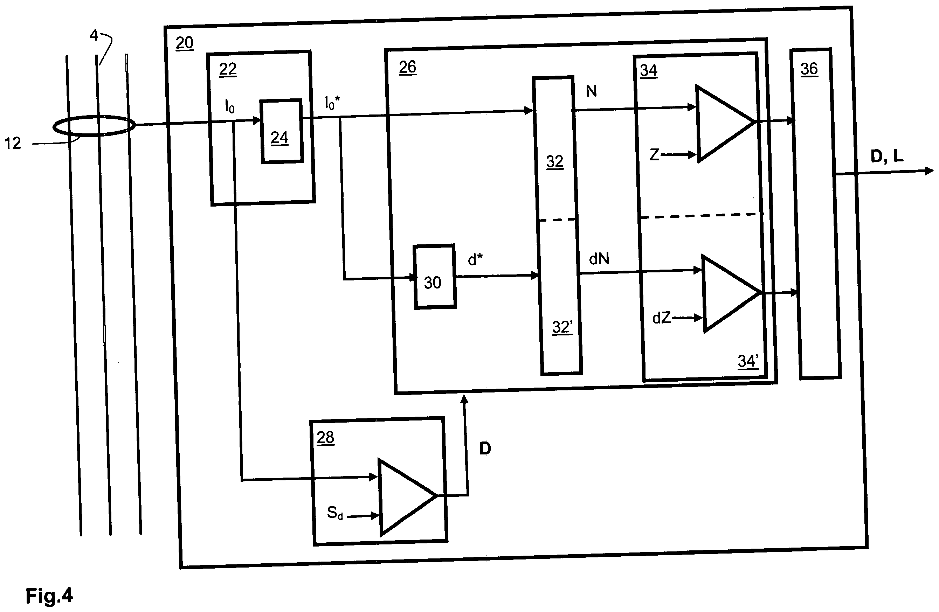

Le procédé selon l'invention peut être mis en place dans un relai de protection 8, dans un indicateur de défaut avec système d'alerte 7, par implémentation dans un dispositif de détection directionnelle de défaut à la terre 20 adapté, schématisé en figure 4 dans un mode de réalisation préféré. Le dispositif 20 comprend des moyens d'obtention d'un signal représentatif du courant homopolaire 22, en provenance des moyens de détermination 12 appropriés. Le capteur 12 associé au dispositif selon l'invention 20 peut être de tout type, en particulier sous forme de tore hippodrome (ou tore homopolaire) entourant l'ensemble des conducteurs de la ligne 4 ; pour les réseaux aériens, il est d'usage que le courant homopolaire I₀ soit déterminé par l'intermédiaire d'un capteur 12 de champ magnétique.

Le signal fourni par les moyens 12 de détermination du courant homopolaire est reçu par les moyens d'obtention 22 du dispositif de détection directionnelle 20 qui comprennent avantageusement un module d'échantillonnage 24, fonctionnant notamment à plus de 20 kHz, pour fournir ainsi un signal échantillonné I₀* à un module de traitement 26, activé en fonction de la détection d'un défaut à la terre 10. A cette fin, le module de traitement 26 est connecté à un dispositif de détection de défaut 28 quelconque ; en particulier, le dispositif de détection de défaut 28 est associé aux moyens 22 d'obtention du signal représentatif du courant homopolaire I₀ et comprend un module de comparaison du courant homopolaire I₀ avec un seuil de détection S_{d} : si le seuil est dépassé, alors un défaut D est détecté et le module de traitement 26 est activé.

Le module de traitement 26 comporte des moyens de détermination 30 de la dérivée d* du signal de courant homopolaire échantillonné I₀*, des moyens de décompte 32 du nombre de passages par zéro du signal de courant homopolaire I₀* et de sa dérivée d*, et des moyens 34 de comparaison des décomptes N, dN obtenus à des seuils Z, dZ. Les moyens de décompte 32 peuvent être uniques avec deux entrées et deux sorties pour les deux signaux ou ils peuvent être dédoublés 32, 32', ne comprenant chacun qu'une entrée et une sortie pour chacun des signaux de courant homopolaire I₀* et de sa dérivée d* ; la même alternative peut être présente pour les moyens de comparaison 34, 34' des décomptes avec les seuils. Les sorties des moyens de comparaison 34, 34' sont communiquées à des moyens d'interprétation 36 dont la sortie est un signal L de détection directionnelle de défaut terre en aval ou en amont des capteurs 12.

Le dispositif de la figure 4 peut être avantageusement associé à un relai de protection 8 pour des réseaux électriques, ou à un indicateur de passage de défaut pour des lignes 4 moyenne tension souterraines connectées en réseau 1, la sortie du module d'interprétation 36 déclenchant la coupure d'un disjoncteur 5, l'allumage d'un voyant 7 ou tout autre moyen de sécurité et/ou d'alerte.

Ainsi, selon l'invention, un procédé et un dispositif de détection directionnelle 20 d'un défaut à la terre 10 d'une ligne d'un réseau multiphasé 1 ont été réalisés sans mesure de tension, ce qui allège autant les dispositifs que leur mise en oeuvre. Qui plus est, un unique capteur de courant 12 est nécessaire, rendant possible l'utilisation du principe selon l'invention consistant à tenir compte des perturbations haute fréquence inhérentes à tout réseau, pour toute configuration, y compris sur des câbles uniques tripolaires, en souterrain ou en aérien, ou dans les réseaux aériens existants quelles que soient leur tension ou la distance entre leurs lignes et donc les champs électromagnétiques induits. En outre, les traitements de l'information fournie par le capteur sont simples, présentant ainsi des facilités en termes de mémoire et de processeur pour ledit dispositif.

Bien que l'invention ait été décrite en référence à un réseau de distribution triphasé dans lequel le neutre est mis à la terre par impédance compensée, elle ne s'y limite pas : d'autres types de réseaux multiphasés peuvent être concernés par l'invention ; en particulier, tout régime de neutre est approprié. Par ailleurs, bien que décrit avec détermination et traitement du courant homopolaire instantané I₀, le procédé selon l'invention peut utiliser la variation dudit courant I₀ par rapport à sa valeur déterminée sur une période préalable : cette variante s'avère particulièrement intéressante dans le cas de réseaux présentant un léger déséquilibre entre phases, dont le courant homopolaire I₀ est donc non nul en situation hors défaut.

De fait, les différents circuits, modules et fonctions présentés dans le cadre du mode de réalisation préféré de l'invention peuvent être réalisés en composants analogiques, numériques ou sous une forme programmable opérant avec des microcontrôleurs ou des microprocesseurs, et les signaux représentatifs décrits peuvent avoir des formes de signaux électriques ou électroniques, de valeurs de données ou d'information dans des mémoires ou des registres, de signaux optiques visualisables notamment sur des voyants ou des écrans, ou de signaux mécaniques agissant avec des actionneurs. De même, le capteur de courant peuvent être différents des exemples présentés, comme un capteur à effet Hall, Peltier, Faraday ou Seebeck, ou des magnétorésistances.

## Revendications

1. Dispositif (20) de détection directionnelle d'un défaut à la terre (10) dans un réseau multiphasé (1) comportant :
- des moyens (22) pour recevoir un signal représentatif du courant homopolaire (I₀) de la ligne (4) du réseau (1) ;
- des moyens (26) de traitement du signal représentatif du courant homopolaire (I₀) comprenant des moyens (32) de détermination d'un premier nombre (N) de passages par zéro du signal sur une durée prédéterminée (T_{acq}) et des moyens (34) de comparaison du premier nombre de passages (N) à un premier seuil (Z);
- des moyens d'activation (28) desdits moyens de traitement (26) en fonction d'un signal (D) de détection de l'occurrence d'un défaut à la terre dans le réseau (1) ;
- des moyens (36) d'interprétation des résultats du traitement du signal pour déterminer si le défaut est en amont du dispositif (20) en fonction des résultats de la comparaison.

2. Dispositif de détection directionnelle (20) selon la revendication 1 dans lequel les moyens (22) pour recevoir le signal représentatif du courant homopolaire (I₀) comprennent des moyens d'échantillonnage (24) à une fréquence supérieure à 400 fois la fréquence du réseau (1).

3. Dispositif de détection directionnelle (20) selon l'une des revendications 1 ou 2 comprenant en outre des moyens (28) de détection de l'occurrence d'un défaut à la terre (10) dans le réseau (1) reliés aux moyens d'activation des moyens de traitement des signaux (26), lesdits moyens de détection (28) comprenant un comparateur du signal représentatif du courant homopolaire (I₀) à un seuil de détection (S_{d}).

4. Dispositif de détection directionnelle (20) selon l'une des revendications 1 à 3 dans lequel les moyens (26) de traitement comprennent en outre des moyens (30) de détermination de la dérivée (d*) par rapport au temps du signal issu des moyens de réception (22), des moyens (32') de détermination d'un deuxième nombre (dN) de passages par zéro de la dérivée (d*) du signal, des moyens (34') de comparaison du deuxième nombre (dN) de passages à un deuxième seuil (dZ) et dans lequel les moyens (36) d'interprétation des résultats du traitement du signal sont aptes à déterminer si le défaut est en amont ou en aval du dispositif (20).

5. Dispositif de détection directionnelle (20) selon la revendication 4 dans lequel la durée prédéterminée (T_{acq}) est supérieure à une demi-période de la fréquence du réseau (1), le premier seuil (Z) est supérieur ou égal à 10 et le deuxième seuil (dZ) est supérieur ou égal à 50.

6. Indicateur de passage de défaut à la terre comprenant un capteur de courant (12) disposés sur la ligne (4) du réseau électrique (1) à surveiller et comprenant un dispositif de détection directionnelle de défaut (20) selon l'une des revendications 1 à 5 connecté audit capteur de courant (12) pour recevoir le signal représentatif du courant homopolaire.

7. Relai (8) de protection à la terre comprenant au moins un indicateur de défaut selon la revendication 6 et des moyens d'actionnement d'un dispositif de coupure (5) en fonction des résultats des moyens d'interprétation (36) du dispositif de détection directionnelle (20) de l'indicateur.

8. Procédé de détection directionnelle (D, L) d'un défaut à la terre (10) dans un réseau multiphasé (1) comprenant le déclenchement, suite à l'obtention d'un signal (D) indicateur de la présence dudit défaut à la terre (10), de la détermination directionnelle (L) du défaut (10), ladite détermination directionnelle comprenant les étapes successives de :
- obtention d'un signal représentatif du courant homopolaire (I₀) sur une durée (T_{acq}) d'au moins une période du réseau (1) ;
- traitement du signal représentatif du courant homopolaire (I₀) comprenant le décompte du nombre de passages par zéro (N) du signal (I₀) sur la durée prédéterminée (T_{acq}) et la comparaison dudit décompte (N) à un premier seuil (Z);
- interprétation des résultats du traitement en fonction des résultats de la comparaison pour indiquer si le défaut détecté (D) se situe en amont de l'endroit où le signal représentatif du courant homopolaire (I₀) a été obtenu.

9. Procédé selon la revendication 8 dans lequel l'obtention d'un signal représentatif du courant homopolaire (I₀) comprend en outre un échantillonnage à une fréquence supérieure à 400 fois la fréquence du réseau (1).

10. Procédé selon l'une des revendications 8 ou 9 dans lequel l'étape de traitement du signal comprend en outre le calcul de la dérivée par rapport au temps du signal représentatif du courant homopolaire (I₀), le décompte d'un deuxième nombre de passages par zéro (dN) de ladite dérivée (d*), et la comparaison du deuxième nombre de passages par zéro (dN) à un deuxième seuil (dZ), et dans lequel l'interprétation des résultats du traitement permet d'indiquer si le défaut détecté (D) se situe en amont ou en aval de l'endroit où le signal représentatif du courant homopolaire (I₀) a été obtenu.

11. Procédé de détection directionnelle selon l'une des revendications 8 à 10 dans lequel le signal (D) indicateur de la présence d'un défaut à la terre (10) est obtenu par comparaison du signal représentatif du courant homopolaire (I₀) à un seuil de détection de défaut (S_{d}).

12. Procédé de protection d'une ligne de courant (5) lors de l'apparition d'un défaut à la terre (10) comprenant l'actionnement d'un dispositif de coupure (6) de ladite ligne (5) si un défaut à la terre (10) a été détecté par un procédé selon l'une des revendications 8 à 11 à l'aval dudit dispositif de coupure (6).

## Patentansprüche

1. Vorrichtung (20) zur Richtungserkennung eines Erdschlusses (10) in einem Mehrphasennetz (1), umfassend:
- Mittel (22) zum Empfangen eines Signals, das für einen gleichpoligen Strom (I₀) der Leitung (4) des Netzes (1) repräsentativ ist;
- Mittel (26) zum Behandeln des Signals, das für den gleichpoligen Strom (I₀) repräsentativ ist, umfassend Mittel (32) zum Bestimmen einer ersten Anzahl (N) von Nulldurchgängen des Signals über eine vorherbestimmte Dauer (T_{acq}) und Mittel (34) zum Vergleichen der ersten Anzahl von Durchgängen (N) mit einer ersten Schwelle (Z);
- Mittel (28) zum Aktivieren der Behandlungsmittel (26) als Funktion eines Signals (D) zur Erkennung des Auftretens eines Erdschlusses in dem Netz (1);
- Mittel (36) zum Interpretieren der Ergebnisse der Behandlung des Signals, um zu bestimmen, ob der Schluss stromaufwärts von der Vorrichtung (20) ist, als Funktion der Ergebnisse des Vergleichs.

2. Vorrichtung (20) zur Richtungserkennung nach Anspruch 1, wobei die Mittel (22) zum Empfangen des Signals, das für den gleichpoligen Strom (I₀) repräsentativ ist, Mittel (24) zum Abtasten bei einer Frequenz von mehr als dem 400-fachen der Frequenz des Netzes (1) umfassen.

3. Vorrichtung (20) zur Richtungserkennung nach einem der Ansprüche 1 oder 2, außerdem umfassend Mittel (28) zum Erkennen des Auftretens eines Erdschlusses (10) in dem Netz (1), die mit den Mitteln zum Aktivieren der Mittel (26) zum Behandeln der Signale verbunden sind, wobei die Erkennungsmittel (28) einen Komparator des Signals, das für den gleichpoligen Strom (I₀) repräsentativ ist, mit einer Erkennungsschwelle (S_{d}) umfassen.

4. Vorrichtung (20) zur Richtungserkennung nach einem der Ansprüche 1 bis 3, wobei die Behandlungsmittel (26) außerdem Mittel (30) zum Bestimmen der Ableitung (d*) in Bezug auf die Zeit des Signals, das von den Empfangsmitteln (22) ausgegeben wird, Mittel (32') zum Bestimmen einer zweiten Anzahl (dN) von Nulldurchgängen der Ableitung (d*) des Signals, Mittel (34') zum Vergleichen der zweiten Anzahl (dN) von Durchgängen mit einer zweiten Schwelle (dZ) umfassen, und wobei die Mittel (36) zum Interpretieren der Ergebnisse der Behandlung des Signals geeignet sind zu bestimmen, ob der Schluss stromaufwärts oder stromabwärts von der Vorrichtung (20) ist.

5. Vorrichtung (20) zur Richtungserkennung nach Anspruch 4, wobei die vorherbestimmte Dauer (T_{acq}) größer ist als eine Halbperiode der Frequenz des Netzes (1), wobei die erste Schwelle (Z) größer oder gleich 10 ist, und die zweite Schwelle (dZ) größer oder gleich 50 ist.

6. Indikator eines Durchgangs eines Erdschlusses, umfassend einen Stromsensor (12), der auf der zu überwachenden Leitung (4) des elektrischen Netzes (1) angeordnet ist, und umfassend eine Vorrichtung (20) zur Richtungserkennung des Schlusses nach einem der Ansprüche 1 bis 5, die mit dem Stromsensor (12) verbunden ist, um das Signal zu empfangen, das für den gleichpoligen Strom repräsentativ ist.

7. Erdschutzrelais (8), umfassend mindestens einen Schlussindikator nach Anspruch 6 und Mittel zum Betätigen einer Trennvorrichtung (5) als Funktion der Ergebnisse der Interpretationsmittel (36) der Vorrichtung (20) zur Richtungserkennung des Indikators.

8. Verfahren zur Richtungserkennung (D, L) eines Erdschlusses (10) in einem Mehrphasennetz (1), umfassend das Auslösen, nach dem Erhalten eines Signals (D), welches das Vorliegen eines Erdschlusses (10) anzeigt, der Richtungsbestimmung (L) des Schlusses (10), wobei die Richtungsbestimmung die aufeinanderfolgenden Schritte umfasst:
- Erhalten eines Signals, das für einen gleichpoligen Strom (I₀) repräsentativ ist, über eine Dauer (T_{acq}) von mindestens einer Periode des Netzes (1);
- Behandeln des Signals, das für den gleichpoligen Strom (I₀) repräsentativ ist, umfassend das Zählen der Anzahl von Nulldurchgängen (N) des Signals (I₀) über die vorherbestimmte Dauer (T_{acq}) und das Vergleichen der Zählung (N) mit einer ersten Schwelle (Z);
- Interpretieren der Ergebnisse der Behandlung als Funktion der Ergebnisse des Vergleichs, um anzuzeigen, ob sich der erkannte Schluss (D) stromaufwärts von dem Ort befindet, wo das Signal, das für den gleichpoligen Strom (I₀) repräsentativ ist, erhalten wurde.

9. Verfahren nach Anspruch 8, wobei das Erhalten des Signals, das für den gleichpoligen Strom (I₀) repräsentativ ist, außerdem ein Abtasten bei einer Frequenz von mehr als dem 400-fachen der Frequenz des Netzes (1) umfasst.

10. Verfahren nach einem der Ansprüche 8 oder 9, wobei der Schritt des Behandelns des Signals außerdem das Berechnen der Ableitung in Bezug auf die Zeit des Signals, das für den gleichpoligen Strom (I₀) repräsentativ ist, das Zählen einer zweiten Anzahl von Nulldurchgängen (dN) der Ableitung (d*) und das Vergleichen der zweiten Anzahl von Nulldurchgängen (dN) mit einer zweiten Schwelle (dZ) umfasst, und wobei die Interpretation der Ergebnisse der Behandlung gestattet anzuzeigen, ob sich der erkannte Schluss (D) stromaufwärts oder stromabwärts von dem Ort befindet, wo das Signal, das für den gleichpoligen Strom (I₀) repräsentativ ist, erhalten wurde.

11. Verfahren zur Richtungserkennung nach einem der Ansprüche 8 bis 10, wobei das Signal (D), welches das Vorliegen eines Erdschlusses (10) anzeigt, durch das Vergleichen des Signals, das für den gleichpoligen Strom (I₀) repräsentativ ist, mit einer Schlusserkennungsschwelle (S_{d}) erhalten wird.

12. Verfahren zum Schützen einer Stromleitung (5) beim Auftreten eines Erdschlusses (10), umfassend die Betätigung einer Trennvorrichtung (6) der Leitung (5), wenn ein Erdschluss (10) durch ein Verfahren nach einem der Ansprüche 8 bis 11 stromabwärts von der Trennvorrichtung (6) erkannt wurde.

## Claims

1. Device (20) for directional detection of an earth fault (10) in a multiphase network (1) including:
- means (22) for receiving a signal representative of the homopolar current (I₀) of the line (4) of the network (1);
- means (26) for processing the signal representative of the homopolar current (I₀) comprising means (32) for determining a first number (N) of zero crossings of the signal over a predetermined duration (T_{acq}) and means (34) for comparing the first number of crossings (N) with a first threshold (Z);
- means (28) for activating said processing means (26) according to a signal (D) of detection of the occurrence of an earth fault in the network (1);
- means (36) for interpreting the results of the processing of the signal so as to determine whether the fault is upstream of the device (20) according to the results of the comparison.

2. Directional detection device (20) according to Claim 1, wherein the means (22) for receiving the signal representative of the homopolar current (I₀) comprise sampling means (24) sampling at a frequency higher than 400 times the frequency of the network (1).

3. Directional detection device (20) according to either of Claims 1 and 2, further comprising means (28) for detecting the occurrence of an earth fault (10) in the network (1), which means are linked to the means for activating the means for processing the signals (26), said detection means (28) comprising a comparator for comparing the signal representative of the homopolar current (I₀) with a detection threshold (S_{d}).

4. Directional detection device (20) according to one of Claims 1 to 3, wherein the processing means (26) further comprise means (30) for determining the derivative (d*) with respect to time of the signal arising from the reception means (22), means (32') for determining a second number (dN) of zero crossings of the derivative (d*) of the signal, means (34') for comparing the second number (dN) of crossings with a second threshold (dZ) and wherein the means (36) for interpreting the results of the processing of the signal are capable of determining whether the fault is upstream or downstream of the device (20).

5. Directional detection device (20) according to Claim 4, wherein the predetermined duration (T_{acq}) is longer than one half-period of the frequency of the network (1), the first threshold (Z) is higher than or equal to 10 and the second threshold (dZ) is higher than or equal to 50.

6. Earth-fault occurrence indicator comprising a current sensor (12) arranged on the line (4) of the electrical network (1) to be monitored and comprising a device for directional fault detection (20) according to one of Claims 1 to 5 that is connected to said current sensor (12) so as to receive the signal representative of the homopolar current.

7. Earth protection relay (8) comprising at least one fault indicator according to Claim 6 and means for actuating a switching device (5) according to the results of the interpreting means (36) of the directional detection device (20) of the indicator.

8. Method for directional detection (D, L) of an earth fault (10) in a multiphase network (1) comprising the triggering, following the obtention of a signal (D) indicative of the presence of said earth fault (10), of the directional determination (L) of the fault (10), said directional determination comprising the successive steps of:
- obtaining a signal representative of the homopolar current (I₀) over a duration (T_{acq}) of at least one period of the network (1);
- processing the signal representative of the homopolar current (I₀) comprising the counting of the number of zero crossings (N) of the signal (I₀) over the predetermined duration (T_{acq}) and the comparison of said count (N) with a first threshold (Z);
interpreting the results of the processing according to the results of the comparison to indicate whether the detected fault (D) is located upstream of the location at which the signal representative of the homopolar current (I₀) has been obtained.

9. Method according to Claim 8, wherein the obtention of a signal representative of the homopolar current (I₀) further comprises sampling at a frequency higher than 400 times the frequency of the network (1).

10. Method according to either of Claims 8 and 9, wherein the step of processing the signal further comprises the calculation of the derivative with respect to time of the signal representative of the homopolar current (I₀), the counting of a second number of zero crossings (dN) of said derivative (d*), and the comparison of the second number of zero crossings (dN) with a second threshold (dZ), and wherein the interpretation of the results of the processing makes it possible to indicate whether the detected fault (D) is located upstream or downstream of the location at which the signal representative of the homopolar current (I₀) has been obtained.

11. Directional detection method according to one of Claims 8 to 10, wherein the signal (D) indicative of the presence of an earth fault (10) is obtained by comparing the signal representative of the homopolar current (I₀) with a fault detection threshold (S_{d}).

12. Method for protecting a power line (5) during the occurrence of an earth fault (10) comprising the actuation of a switching device (6) of said line (5) if an earth fault (10) has been detected by a method according to one of Claims 8 to 11 downstream of said switching device (6).
